# DEMANDE DE BREVET EUROPEEN

(11) **EP 3 823 040 A1**
(43) Date de publication de la demande: **19.05.2021**
(21) Numéro de dépôt: 20207590.9
(22) Date de dépôt: 13.11.2020
(51) Int. Cl.: H01L 29/808, H01L 21/337, H01L 29/06, H01L 29/732, H01L 27/06, H01L 21/8248

(54) **CIRCUIT INTÉGRÉ COMPRENANT UN TRANSISTOR JFET ET PROCÉDÉ DE FABRICATION D'UN TEL CIRCUIT INTÉGRÉ**

(30) Priorité: 15.11.2019 FR 1912782
(71) Demandeur: STMicroelectronics Crolles 2 SAS, 38920 Crolles (FR)
(72) Inventeur: JIMENEZ MARTINEZ, Jean, 11110 SALLES D'AUDE (FR)
(74) Mandataire: Casalonga

(57) **Abrégé**

L'invention concerne un circuit intégré comprenant un substrat (12) semiconducteur et un transistor à effet de champ à jonction formé dans le substrat (12), le transistor comprenant :
- une région de drain (14) et une région de source (15),
- une région de canal (17),
- une région de grille (16),
dans lequel le transistor comprend :
- une première région isolante (18) séparant la région de drain (14) de la région de grille (16) et de la région de canal, et une deuxième région isolante (19) séparant la région de source (15) de la région de grille (16) et de la région de canal,
- une première région de liaison (20) reliant la région de drain (14) à la région de canal (17), et une deuxième région de liaison (21) reliant la région de source (15) à la région de canal (17).

## Description

Des modes de mise en œuvre et de réalisation de l'invention concernent les circuits intégrés, en particulier ceux comprenant des transistors à effet de champ à jonction (JFET) et la fabrication de tels circuits intégrés.

Les transistors JFET présentent généralement un faible bruit électrique en sortie, et ont généralement une bonne tenue en haute tension. Par exemple, on trouve des transistors JFET dans les étages d'entrée d'amplificateur opérationnels de précision et à haute impédance d'entrée.

Il est connu de former un transistor JFET dans un substrat semiconducteur. Le transistor JFET comprend une région de source et une région de drain espacées l'une de l'autre. Le transistor JFET comprend également une région de canal s'étendant depuis la région de drain jusqu'à la région de source. Le transistor JFET comprend en outre une région de grille s'étendant sur la région de canal depuis la région de drain jusqu'à la région de source.

Les régions de source et de drain sont en outre diffusées par implantation profondément dans le substrat semiconducteur, c'est-à-dire plus profondément que la région de canal du transistor.

Ces régions de source et de drain sont diffusées profondément pour soutenir une haute tension, notamment de l'ordre de 40Volts. Néanmoins, ces régions diffusées profondément présentent l'inconvénient d'induire des capacités parasites entre la région de drain et la région de grille ainsi qu'entre la région de source et la région de grille.

Ces capacités parasites réduisent les performances en haute fréquence des transistors JFET et limitent donc l'utilisation des transistors JFET à certaines applications.

Il existe donc un besoin de pouvoir proposer un transistor JFET ayant des capacités parasites de façon à présenter de bonnes performances en haute fréquence.

Selon un aspect, il est proposé un circuit intégré comprenant un substrat semiconducteur et un transistor à effet de champ à jonction formé dans le substrat, le transistor comprenant :
- une région de drain et une région de source espacées l'une de l'autre,
- une région de canal entre la région de drain et la région de source,
- une région de grille entre la région de drain et la région de source, dans lequel le transistor comprend en outre au sein du substrat :
- une première région isolante séparant la région de drain de la région de grille et de la région de canal, et une deuxième région isolante séparant la région de source de la région de grille et de la région de canal,
- une première région de liaison reliant la région de drain à la région de canal en contournant la première région isolante, et une deuxième région de liaison reliant la région de source à la région de canal en contournant la deuxième région isolante.

La région de canal et la région de grille s'étendent donc à partir d'une première face latérale de la première région isolante jusqu'à une première face latérale de la deuxième région isolante.

La région de canal et la région de grille présente ainsi une première extrémité contre la première face latérale de la première région isolante et une deuxième extrémité contre la première face latérale de la deuxième région isolante.

La région de drain est disposée au contact d'une deuxième face latérale de la première région isolante opposée à la première face latérale de la première région isolante.

La région de source est disposée au contact d'une deuxième face latérale de la deuxième région isolante opposée à la première face latérale de la deuxième région isolante.

Ainsi, la première région isolante et la deuxième région isolante s'étendent plus profondément que la région de canal, la région de source et la région de drain du transistor.

Les régions de liaison permettent de connecter la région de source à la première extrémité de la région de canal et de connecter la région de drain à la deuxième extrémité de la région de canal.

En particulier, le fait d'isoler les régions de drain et de source de la région de grille et de la région de canal permet de réduire les capacités parasites entre les régions de drain et de source et la région de grille. Cette réduction des capacités parasites permet de soutenir des hautes tensions.

En particulier, selon un mode de réalisation, la région de drain et la région de source sont diffusées en surface sur une profondeur permettant de réduire des capacités parasites.

Ainsi, selon un mode de réalisation, la région de source et la région de drain s'étendent en profondeur depuis la face avant du substrat jusqu'au niveau d'une face inférieure de la région de canal.

Un tel transistor JFET comprend donc une région de canal et une région de drain diffusées en surface du substrat semiconducteur et isolées de la région de grille et de la région de canal. Cette structure permet de soutenir des hautes tensions avec des faibles capacités parasites.

En particulier, le fait d'isoler les régions de drain et de source de la région de grille et de la région de canal permet également de ne pas avoir à diffuser profondément les régions de drain et de source. En outre, le fait de diffuser uniquement en surface la région de drain et la région de source permet également de réduire des capacités parasites. Cette réduction des capacités parasites permet également de soutenir des hautes tensions.

En outre, chaque région de liaison s'étend ainsi sous et contre la région isolante qu'elle contourne en profondeur.

Selon un mode de réalisation, la première région isolante et la deuxième région isolante s'étendent dans le substrat depuis la face avant du substrat. En particulier, chaque région de liaison possède :
- une première partie s'étendant verticalement dans le substrat au contact d'une première face latérale de la région isolante correspondante depuis la face inférieure de la région de canal,
- une deuxième partie horizontale s'étendant horizontalement dans le substrat au contact d'une face inférieure de la région isolante correspondante, et
- une troisième partie s'étendant verticalement dans le substrat au contact d'une deuxième face latérale de la région isolante correspondante jusqu'à contacter la région correspondante de source ou de drain.

Selon un mode de réalisation, la région de drain, la région de source, la région de canal, la première région de liaison et la deuxième région de liaison présentent un premier type de conductivité. En outre, la région de grille présente un deuxième type de conductivité.

Ainsi, le transistor JFET peut par exemple présenter un canal de type P. La région de drain, la région de source, la région de canal, la première région de liaison et la deuxième région de liaison présentent alors une conductivité de type P. La région de grille présente alors une conductivité de type N.

Le transistor JFET peut en variante présenter un canal de type N. La région de drain, la région de source, la région de canal, la première région de liaison et la deuxième région de liaison présentent alors une conductivité de type N. La région de grille présente alors une conductivité de type P.

Le circuit intégré peut comprendre une pluralité de transistors JFET tels que ceux décrits précédemment.

Selon un mode de réalisation, le circuit intégré comprend en outre au moins un transistor bipolaire ayant des régions de dérive de même type de conductivité que celui des régions de liaison du transistor JFET.

Ces régions de dérive sont connues par l'homme du métier sous la dénomination anglosaxonne de « drift regions ».

Le circuit intégré peut comprendre une pluralité de transistors JFET comprenant des régions de liaison et une pluralité de transistors bipolaires comprenant des régions de dérive.

Selon un autre aspect, il est proposé un procédé de fabrication d'un circuit intégré comprenant une formation dans un substrat d'un transistor à effet de champ à jonction comprenant :
- une formation d'une région de drain et d'une région de source espacées l'une de l'autre,
- une formation d'une région de canal entre la région de drain et la région de source,
- une formation d'une région de grille sur la région de canal entre la région de drain et la région de source,
   dans lequel le procédé comprend en outre :
- une formation d'une première région isolante séparant la région de

drain de la région de grille et de la région de canal et d'une deuxième région isolante séparant la région de source de la région de grille et de la région de canal, - une formation d'une première région de liaison reliant la région de drain à la région de canal en contournant la première région isolante et d'une deuxième région de liaison reliant la région de source à la région de canal en contournant la deuxième région isolante.

Selon un mode de mise en œuvre, la formation de la première région de liaison et de la deuxième région de liaison comprend une implantation de dopants.

Selon un mode de mise en œuvre, le procédé de fabrication comprend en outre une formation, dans le substrat, d'au moins un transistor bipolaire ayant une base, un émetteur et un collecteur et des régions de dérive ayant le même type de conductivité que celui des régions de liaison. En outre, la formation de la première région de liaison et de la deuxième région de liaison et la formation des régions de dérive sont réalisées à partir d'un même masque.

Selon un mode de mise en œuvre, la formation de la première région de liaison et la formation de la deuxième région de liaison sont effectuées simultanément avec la formation de la région de dérive.

Ainsi, la formation de la première région de liaison et la formation de la deuxième région de liaison ne nécessite pas une étape dédiée supplémentaire. Et, les formations de la première région de liaison et de la deuxième région de liaison sont peu coûteuses.

D'autres avantages et caractéristiques de l'invention apparaîtront à l'examen de la description détaillée de modes de mise en œuvre et de réalisation, nullement limitatifs, et des dessins annexés sur lesquels :
[Fig 1],
[Fig 2],
[Fig 3],

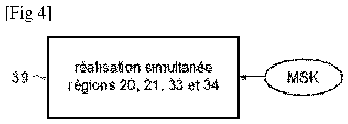

[Fig 4] illustrent schématiquement des modes de réalisation et de mises en œuvre de l'invention.

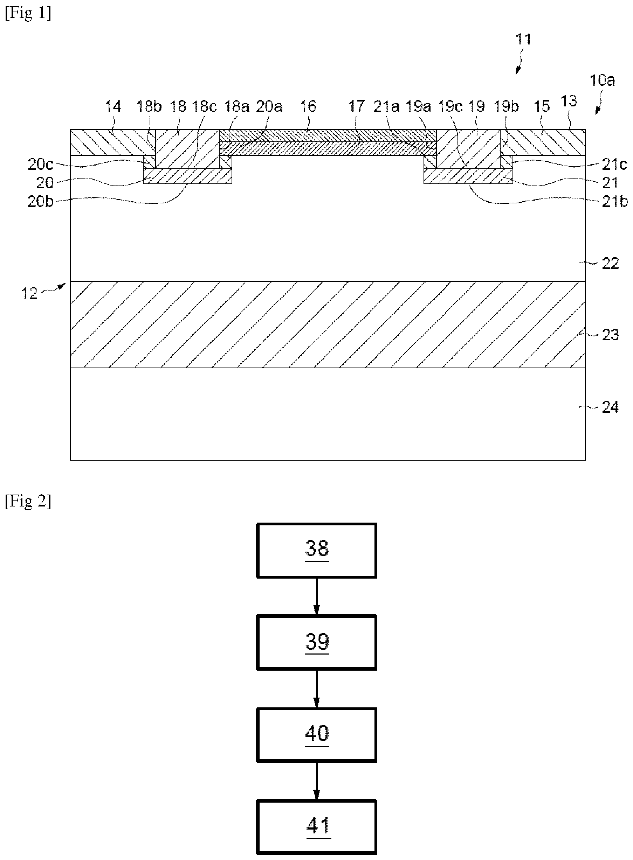

La figure 1 représente un circuit intégré 10a selon un mode de réalisation de l'invention qui comprend un transistor à effet de champ à jonction, dit transistor JFET 11, formé dans un substrat 12 semiconducteur. Le substrat 12 semiconducteur présente une face avant 13.

Le transistor JFET 11 comprend une région de drain 14 et une région de source 15 espacées l'une de l'autre. La région de drain 14 et la région de source 15 présentent une conductivité d'un premier type (N ou P). En particulier, la région de drain 14 et la région de source 15 s'étendent chacune en profondeur depuis la face avant 13 du substrat 12 semiconducteur sur une distance de l'ordre de 0,2 µm à 0,3 µm..

Le transistor JFET 11 comprend en outre une région de grille 16 entre la région de drain 14 et la région de source 15. La région de grille 16 présente une conductivité d'un deuxième type (N ou P) distinct du premier type de conductivité. La région de grille 16 s'étend en profondeur depuis la face avant 13 du substrat 12 semiconducteur sur une distance de l'ordre de 0,2 µm.

Le transistor JFET 11 comprend également une région de canal 17 entre la région de drain 14 et la région de source 15. La région de canal 17 présente une conductivité dudit premier type. La région de grille 16 s'étend en profondeur depuis la région de grille 16 sur une distance de l'ordre de 0,4 µm.

Le transistor JFET 11 comprend en outre au sein du substrat 12 une première région isolante 18 séparant la région de drain 14 de la région de grille 16 et de la région de canal 17.

Le transistor JFET 11 comprend également au sein du substrat 12 une deuxième région isolante 19 séparant la région de source 15 de la région de grille 16 et de la région de canal 17.

En particulier, la première région isolante 18 et la deuxième région isolante 19 s'étendent chacune en profondeur depuis la face avant 13 du substrat 12 semiconducteur sur une distance de l'ordre de 1 µm. Ainsi, la première région isolante 18 et la deuxième région isolante 19 s'étendent plus profondément que la région de canal 17, la région de source 15 et la région de drain 14 du transistor.

La première région isolante 18 et la deuxième région isolante 19 peuvent comprendre par exemple du dioxyde de silicium.

Plus particulièrement, la région de canal 17 et la région de grille 16 s'étendent à partir d'une première face latérale 18a de la première région isolante 18 jusqu'à une première face latérale 19a de la deuxième région isolante 19.

La région de canal 17 et la région de grille 16 présentent ainsi chacune une première extrémité longitudinale contre la première face latérale 18a de la première région isolante 18 et une deuxième extrémité longitudinale contre la première face latérale 19a de la deuxième région isolante 19.

En outre, la région de drain 14 est disposée au contact d'une deuxième face latérale 18b de la première région isolante 18 opposée à la première face latérale 18a de la première région isolante 18.

La région de source 15 est disposée au contact d'une deuxième face latérale 19b de la deuxième région isolante 19 opposée à la première face latérale 19a de la deuxième région isolante 19.

Le transistor JFET 11 comprend également au sein du substrat 12 une première région de liaison 20 reliant la région de drain 14 à la région de canal 17 en contournant en profondeur la première région isolante 18.

En particulier, la première région de liaison 20 comprend une première partie 20a s'étendant verticalement dans le substrat 12 au contact de ladite première face latérale 18a de la première région isolante 18 depuis la région de canal 17.

La première région de liaison 20 comprend une deuxième partie 20b horizontale s'étendant horizontalement dans le substrat 12 au contact d'une face inférieure 18c de la première région isolante 18.

La première région de liaison 20 comprend également une troisième partie 20c s'étendant verticalement dans le substrat 12 au contact de la deuxième face latérale 18b de la première région isolante 18 jusqu'à contacter la région de drain 14.

Le transistor JFET 11 comprend également au sein du substrat 12 une deuxième région de liaison 21 reliant la région de source 15 à la région de canal 17 en contournant en profondeur la deuxième région isolante 19.

En particulier, la deuxième région de liaison 21 comprend une première partie 21a s'étendant verticalement dans le substrat 12 au contact de ladite première face latérale 19a de la deuxième région isolante 19 depuis la région de canal 17.

La deuxième région de liaison 21 comprend une deuxième partie 21b horizontale s'étendant horizontalement dans le substrat 12 au contact d'une face inférieure de la deuxième région isolante 19.

La deuxième région de liaison 21 comprend également une troisième partie 21c s'étendant verticalement dans le substrat 12 au contact de la deuxième face latérale 19b de la deuxième région isolante 19 jusqu'à contacter la région de source 15.

La première région de liaison 20 permet de connecter la région de drain 14 à la région de canal 17. La deuxième région de liaison 21 permet de connecter la région de source 15 à la région de canal 17.

Le transistor JFET 11 est formé ici dans un caisson 22 dopé N⁻, surmontant une couche enterrée 23 dopée N⁺, elle-même située au-dessus d'un substrat porteur 24 dopé P⁻.

Le transistor JFET 11 présente ici un canal de type P. La région de drain 14, la région de source 15, la région de canal 17, la première région de liaison 20, la deuxième région de liaison 21 et le substrat porteur 24 du substrat 12 semiconducteur présentent alors une conductivité de type P. En outre, la région de grille 16, le caisson 22 et la couche enterrée 23 présentent une conductivité de type N.

En particulier, la région de drain 14 et la région de source 15 ont une concentration de dopants de l'ordre de 5×10¹⁹ atomes/cm³ à 2×10²⁰ atomes/cm³.

La région de canal 17 a une concentration de dopants de l'ordre de 10¹⁶ atomes/cm³.

La région de grille 16 a une concentration de dopants de l'ordre de 10¹⁷ atomes/cm³.

La première région de liaison 20 et la deuxième région de liaison 21 a une concentration de dopants de l'ordre de 10¹⁷ atomes/cm³.

Le caisson 22 a une concentration de dopants de l'ordre de 10¹⁵ atomes/cm³.

La couche enterrée 23 a une concentration de dopants de l'ordre de 10¹⁹ atomes/cm³ à 2×10¹⁹ atomes/cm³.

Le substrat porteur 24 a une concentration de dopants de l'ordre de 10¹⁹ atomes/cm³ à 2×10¹⁹ atomes/cm³.

En variante, le transistor JFET 11 peut présenter un canal de type N. La région de drain 14, la région de source 15, la région de canal 17, la première région de liaison 20, la deuxième région de liaison 21 et le substrat porteur présentent alors une conductivité de type N. En outre, la région de grille 16, le caisson 22 et la couche enterrée présentent une conductivité de type P.

Le fait d'isoler les régions de drain et de source de la région de grille 16 et de la région de canal 17 permet de réduire les capacités parasites entre les régions de drain et de source et la région de grille 16. Le fait de diffuser uniquement en surface la région de drain 14 et la région de source 15 permet également de réduire des capacités parasites. Cette réduction des capacités parasites permet de soutenir des hautes tensions. Par exemple, un tel transistor JFET 11 permet d'obtenir des tensions de claquage de l'ordre de 80Volts.

La figure 2 représente un exemple de procédé de fabrication d'un circuit intégré tel que celui représenté à la figure 1. Dans une étape 38, on procède par implantation de dopants dans le substrat porteur 24 à la réalisation de la couche enterrée 23, puis à la réalisation, par épitaxie, du caisson 22.

Dans l'étape 39, on forme par masquage et implantation de dopants dans le caisson 22, les régions de liaison 20 et 21.

Puis on forme dans l'étape 40, les régions isolantes 18 et 19 avant de procéder par implantation de dopants dans l'étape 41, à la réalisation de la région de canal 17 et à la réalisation des régions de drain et de source 18 et 19.

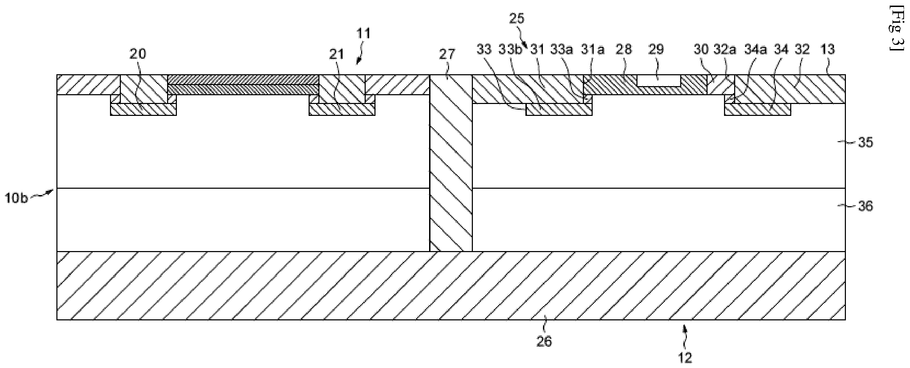

La figure 3 représente un circuit intégré 10b selon un mode de réalisation de l'invention comprenant un transistor JFET 11 tel que décrit précédemment et un transistor bipolaire 25.

Le transistor JFET 11 et le transistor bipolaire 25 sont formés à partir du même substrat porteur 26.

Le transistor JFET 11 est séparé du transistor bipolaire 25 par une tranchée 27 d'isolation peu profonde (connue sous l'acronyme « STI » de l'anglais « *Shallow Trench Isolation »).*

Le transistor bipolaire 25 est ici un transistor NPN. Il comporte de façon classique une région de collecteur intrinsèque formée dans le caisson 35, une région de base intrinsèque 28, une région de base extrinsèque 30 et une région d'émetteur 29. Le transistor bipolaire 25 comporte également des régions de dérive 34 et 33 situées sous des régions d'isolation 31 et 32 et contactant la région de base intrinsèque et la région de base extrinsèque.

Les régions de dérives 33 et 34 sont de même type de conductivité que celui des régions de liaison 20, 21 du transistor JFET 11.

En variante ou en combinaison, le circuit intégré 10b peut comprendre un transistor JFET 11 à canal de type N et un transistor bipolaire 25 PNP.

Le procédé de fabrication d'un circuit intégré tel que celui représenté à la figure 3 comprend une formation d'un transistor JFET 11 telle que décrite précédemment.

Le procédé de fabrication comprend en outre une formation classique du transistor bipolaire 25.

Par ailleurs, comme illustré à la figure 4, la formation de la première région de liaison 20 et de la deuxième région de liaison 21 et la formation des régions de dérive 33, 34 sont réalisées dans l'étape 39 à partir d'un même masque MSK. En outre, au cours de cette étape 39, la formation de la première région de liaison 20 et la formation de la deuxième région de liaison 21 sont avantageusement effectuées simultanément avec la formation des régions de dérive.

Ainsi, la formation de la première région de liaison 20 et la formation de la deuxième région de liaison 21 ne nécessite pas une étape dédiée supplémentaire. Ainsi, les formations de la première région de liaison 20 et de la deuxième région de liaison 21 sont peu coûteuses.

## Revendications

1. Circuit intégré comprenant un substrat (12) semiconducteur et un transistor à effet de champ à jonction formé dans le substrat (12), le transistor comprenant :
- une région de drain (14) et une région de source (15) espacées l'une de l'autre,
- une région de canal (17) entre la région de drain (14) et la région de source (15),
- une région de grille (16) entre la région de drain (14) et la région de source (15),
dans lequel le transistor comprend en outre au sein du substrat (12) :
- une première région isolante (18) séparant la région de drain (14) de la région de grille (16) et de la région de canal, et une deuxième région isolante (19) séparant la région de source (15) de la région de grille (16) et de la région de canal,
- une première région de liaison (20) reliant la région de drain (14) à la région de canal (17) en contournant la première région isolante, et une deuxième région de liaison (21) reliant la région de source (15) à la région de canal (17) en contournant la deuxième région isolante (19).

2. Circuit intégré selon la revendication 1, dans lequel le substrat (12) comporte une face avant (13), la région de source (15) et la région de drain (14) s'étendant en profondeur depuis la face avant (13) du substrat (12) jusqu'au niveau d'une face inférieure de la région de canal (17).

3. Circuit intégré selon la revendication 2, dans lequel la première région isolante (18) et la deuxième région isolante (19) s'étendent dans le substrat (12) depuis la face avant (13) du substrat (12),
et dans lequel chaque région de liaison (20, 21) possède une première partie (20a, 21a) s'étendant verticalement dans le substrat (12) au contact d'une première face latérale (18a, 19a) de la région isolante (18, 19) correspondante depuis la face inférieure de la région de canal (17), une deuxième partie (20b, 21b) horizontale s'étendant horizontalement dans le substrat (12) au contact d'une face inférieure (18c, 19c) de la région isolante (18, 19) correspondante, et une troisième partie (20c, 21c) s'étendant verticalement dans le substrat (12) au contact d'une deuxième face latérale (18b, 19b) de la région isolante (19, 19) correspondante jusqu'à contacter la région correspondante de source ou de drain (14, 15).

4. Circuit intégré selon l'une des revendications 1 à 3, dans lequel :
- la région de drain (14), la région de source (15), la région de canal (17), la première région de liaison (20) et la deuxième région de liaison (21) présentent un premier type de conductivité,
- la région de grille (16) présente un deuxième type de conductivité.

5. Circuit intégré selon l'une des revendications précédentes, comprenant en outre au moins un transistor bipolaire (25) ayant des régions de dérive (33, 34) de même type de conductivité que celui des régions de liaison (20, 21).

6. Procédé de fabrication d'un circuit intégré comprenant une formation dans un substrat (12) d'un transistor à effet de champ à jonction comprenant :
- une formation d'une région de drain (14) et d'une région de source (15) espacées l'une de l'autre,
- une formation d'une région de canal (17) entre la région de drain (14) et la région de source (15),
- une formation d'une région de grille (16) sur la région de canal (17) entre la région de drain (14) et la région de source (15),
dans lequel le procédé comprend en outre :
- une formation d'une première région isolante séparant la région de drain (14) de la région de grille (16) et de la région de canal et d'une deuxième région isolante (19) séparant la région de source (15) de la région de grille (16) et de la région de canal,
- une formation d'une première région de liaison (20) reliant la région de drain (14) à la région de canal (17) en contournant la première région isolante et d'une deuxième région de liaison (21) reliant la région de source (15) à la région de canal (17) en contournant la deuxième région isolante (19).

7. Procédé selon la revendication 6 dans lequel la formation de la première région de liaison (20) et de la deuxième région de liaison (21) comprend une implantation de dopants.

8. Procédé selon la revendication 7 comprenant en outre une formation, dans le substrat (12), d'au moins un transistor bipolaire (25) ayant une base, un émetteur et un collecteur et des régions de dérive (33, 34) ayant le même type de conductivité que celui des régions de liaison,
et dans lequel la formation de la première région de liaison (20) et de la deuxième région de liaison (21) et la formation des régions de dérive (33, 34) sont réalisées à partir d'un même masque.

9. Procédé selon la revendication 8 dans lequel la formation de la première région de liaison (20) et la formation de la deuxième région de liaison (21) sont effectuées simultanément avec la formation de la région de dérive.
